# EUROPÄISCHE PATENTSCHRIFT

(11) **EP 0 487 624 B1**
(45) Veröffentlichungstag und Bekanntmachung des Hinweises auf die Patenterteilung: **11.01.1995**
(21) Anmeldenummer: 90913301.9
(22) Anmeldetag: 14.08.1990
(51) Int. Cl.: H03J 5/02

(54) **VERFAHREN ZUR PROGRAMMPLATZ-SORTIERUNG**
PROCESS FOR PROGRAMME SETTING SEQUENCING
PROCEDE DE SEQUEN AGE DES REGLAGES DE PROGRAMME

(30) Priorität: 23.08.1989 DE 3927837
(43) Veröffentlichungstag der Anmeldung: 03.06.1992
(73) Patentinhaber: Deutsche Thomson-Brandt GmbH, 78010 Villingen-Schwenningen (DE)
(72) Erfinder: EIGELDINGER, Norbert, D-7730 Villingen-Schwenningen (DE); FECHNER, Rainer, D-7730 Villingen-Schwenningen (DE); SANYA, Olufemi, D-7730 Villingen-Schwenningen (DE)
(86) Internationale Anmeldenummer: EP9001334
(87) Internationale Veröffentlichungsnummer: WO9103102

(56) Entgegenhaltungen:
- DE-A- 3 316 805
- DE-A- 3 733 028
- GB-A- 2 056 207
- GB-A- 2 063 600
- Patent Abstracts of Japan, Vol 8, No. 4, (E-220)(1441), 10 Jan. 1984, and JP,A,58171122 (tokyo shibaura denki kk) 7 OCTOBER 1983 see abstract

## Beschreibung

Bei Geräten der Unterhaltungselektronik, z.B. bei Videorecordern ist es bekannt, in einer Speichervorrichtung des Gerätes am Ort empfangbare Sender einzuprogrammieren, um diese durch Tastenbetätigung zwecks einfacher Bedienung am Gerät oder auch mittels Fernbedienung abrufen zu können. Dabei ist einem Programmplatz oder einer Programmnummer ein bestimmter Sender mit seiner Kanalnummer, die einer bestimmten Frequenz entspricht, zugeordnet. Moderne Geräte weisen eine Vielzahl von abrufbaren Programmplätzen auf, wobei die Zahl der Plätze die Möglichkeit empfangbarer Stationen durchaus überschreiten kann. Bei einem derartigen Gerät wäre es möglich, innerhalb eines größeren Empfangsgebietes alle theoretisch zu empfangenen Empfangskanäle in einem Programmiervorgang jeweils einer Programmplatznummer zuzuordnen. Von dieser Vielzahl einprogrammierter Kanäle sind aber am Empfangsort nur einige zu empfangen. Es ist daher zweckmäßig, aus Übersichtsgründen die empfangbaren Kanäle z.B. nach steigender Zuordnung der Programmplatznummer zu sortieren. Dieses kann durch individuelle Programmierung geschehen. Auch bei Wechsel des Empfangsortes müßte die individuelle Programmierung erneut durchgeführt werden. Derartige Neuprogrammierungen bedeuten allerdings einen großen Zeitaufwand.

Es ist Aufgabe der Erfindung, durch ein einfaches Sortierverfahren aus der Vielzahl bereits einprogrammierter Kanäle eine gewünschte Zordnung empfangbarer Kanäle zu den Programmplatznummern z.B. in steigender Zuordnung zu ermöglichen.

Diese Aufgabe wird gemäß der Erfindung durch die im Anspruch 1 aufgeführten Merkmale gelöst. Vorteilhafte Weiterbildungen der Erfindung sind in den Unteransprüchen gekennzeichnet.

Im Prinzip werden jeweils von zwei Programmplätzen, die nacheinander aufgerufen werden, die darin gespeicherten Kenndaten (Kanalnummern) durch interne Steuerung im Gerät miteinander getauscht.

Dadurch ist es auf einfache Weise möglich, eine gewünschte Zuordnung der empfangbaren Kanäle zu ermöglichen. Um für den Bedienenden den Sortiervorgang möglichst einfach zu gestalten, werden zeitliche Abläufe gewählt, durch die der Bedienende geführt wird. Durch Betätigen einer zum Tausch vorgesehenen Programmtaste für eine längere Zeitdauer von etwa 1 - 4 Sec. wird der zugehörige Programmplatz (Programm-NR) mit den eingespeicherten Kenndaten (Kanal-NR) intern zum Vertauschen markiert. Der Vertauschvorgang wird dadurch eingeleitet, daß die dieser Programmtaste zugehörigen Daten in einen Hilfsspeicher eingelesen werden. Bei Geräten mit einer Anzeige werden außerdem die eingelesenen Daten (Programm-NR und Kanal-NR) zur Anzeige gebracht. Gleichzeitig läuft eine interne Uhr an, die z.B. in einem Mikroprozessor enthalten ist, oder aus einem Taktgenerator und einem Zähler zwecks Eröffnung eines Zeitfensters etwa für 5 Sec. gebildet ist. Das Zeitfenster kann ebenfalls zur Anzeige gebracht werden, z.B. durch Blinken der bereits zum Vertausch angezeigten Daten oder auch durch ein besonderes Symbol.

Bei Betätigen einer zweiten Programmplatztaste, deren Kenndaten (Kanal-NR) mit der der ersten Taste vertauscht werden sollen, ebenfalls über eine längere Zeitdauer von 1 - 4 Sec. innerhalb des vorgegebenen Zeitfensters von 5 Sec., werden auch diese Daten in einen Hilfsspeicher eingelesen. Gleichzeitig erfolgt ebenfalls eine Anzeige für die diesem Programmplatz zugehörigen Daten (Programm-Nr und Kanal-NR). Durch einen ansich aus der Computertechnik bekannten Austausch der Kenndaten (Kanal-NR) der beiden aufgerufenen Programmplätze mit Hilfe eines Prozessors, über den auch die Anzeigen gesteuert werden, erfolgt so die gewünschte Zuordnung. Der erfolgte Austausch kann ebenfalls als Bestätigung an der Anzeige dargestellt werden.

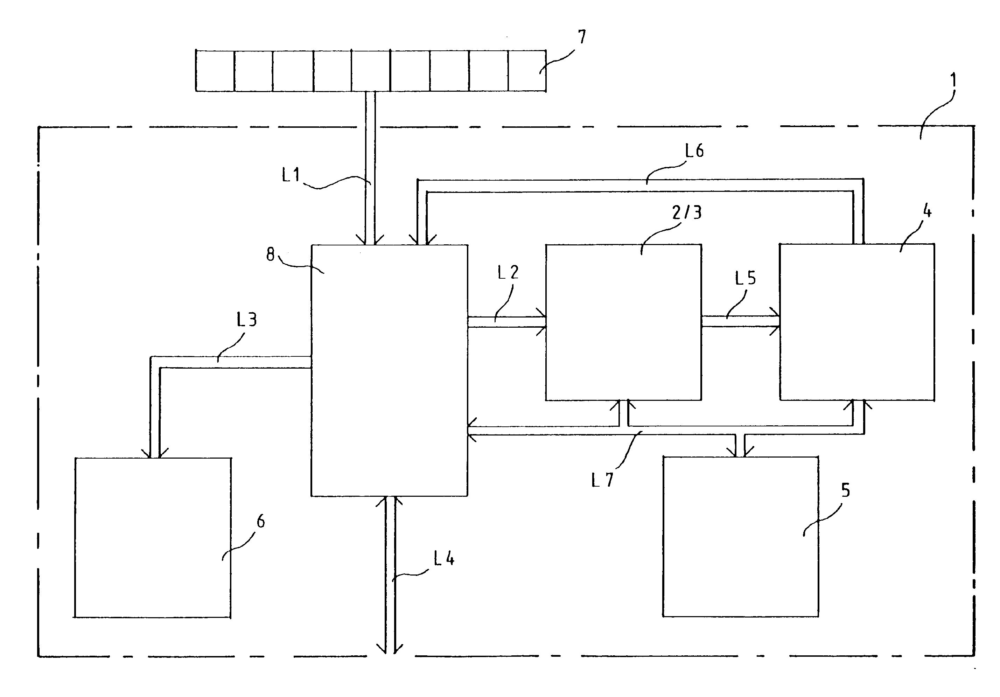

Im folgenden soll die Erfindung anhand einer Figur beispielhaft näher erläutert werden.
Die Figur zeigt ein Blockschaltbild für den Sortiervorgang. Eine Speichereinrichtung 1 weist einen Hauptspeicher 8 auf, der als dynamischer RAM-Speicher ausgebildet sein kann. Es soll vorausgesetzt werden, daß in dem Hauptspeicher 8 bereits den einzelnen Programmplätzen (PR-NR) Kenndaten (Kanal-NR) zugeordnet sind. Jeweils einem Programmplatz (PR-NR) ist eine Taste in der Tastatur 7 zugeordnet. Bei Betätigen einer Taste werden über Leitung L1 gesteuert, die zugehörigen, in Hauptspeicher 8 gespeicherten Kenndaten (Kanal-NR) ausgegeben. Die Steuerung geschieht in Verbindung mit Mikroprozessor 5 über die Datenleitung L7. Einerseits können über Leitung L3 die Daten an eine Anzeige 6 und andererseits über Leitung L4 an nicht dargestellte Schaltungen im Gerät zwecks Durchführung eingegebener Steuerbefehle ausgegeben werden.

Erfindungsgemäß wird durch längeres Betätigen einer Taste in der Tastatur 7 für etwa 1 - 4 Sec. der betreffende Programmplatz zu einem Datentausch markiert. Diese Technik der Markierung ist bereits z.B. beim Programmieren von Uhren oder auch von Videorecordern bekannt und soll hier nicht näher erläutert werden. Ist auf diese Weise ein erster Programmplatz für einen Datentausch ausgewählt, werden die Daten für PR-NR und für die Kanal-NR über Leitung L2 vom Hauptspeicher 8 in den Hilfsspeicher 2/3 eingegeben, und gleichzeitig im Anzeigefeld 6 über Leitung L3 sichtbar gemacht. Außerdem wird durch den Mikroprozessor 5 ein Zeitfenster von etwa 5 Sec. geöffnet. Wenn innerhalb des vorgegebenen Zeitfensters eine zweite Taste, ebenfalls über einen Zeitraum von 1 - 4 Sec. betätigt wird, werden die darin gespeicherten Daten (PR-NR und Kanal-NR) ebenfalls in den Hilfsspeicher 2/3 eingegeben und an Anzeigefeld 6 sichtbar gemacht. Sind die Daten von der ersten Taste und der zweiten Taste in Hilfsspeicher 2/3 eingelesen, läuft, gesteuert vom Mikorprozessor 5 ein Tauschvorgang ab. Hierzu werden aus dem Hilfsspeicher 2/3 die Daten in einen weiteren Hilfsspeicher 4 über Leitung L5 so eingelesen, daß der ersten PR-NR die zweite Kanal-NR und der zweiten PR-NR die erste Kanal-NR zugeordnet ist. Diese neu sortierten Daten werden anschließend über Leitung L6 in den Hauptspeicher 8 durch überschreiben der Kenndaten (Kanal-NR) bei Beibehaltung der PR-NR eingelesen und außerdem am Anzeigefeld 6 als Bestätigung des Tauschvorganges sichtbar gemacht. Bei Ablauf des gesetzten Zeitfensters ist der Vorgang abgeschlossen und weitere Tauschvorgänge können anschließend durchgeführt werden. Wenn innerhalb des Zeitfensters ein zweite Taste nicht betätigt wird, fällt nach Ablauf der Zeit das System in seinen bereits bestehenden Zustand zurück.

## Patentansprüche

1. Verfahren zur Programmplatz-Sortierung in einem Gerät der Unterhaltungselektronik, bei dem in einer Speichereinrichtung (1) durch Programmierung jeweils einem durch eine Taste in einer Tastatur (7) anwählbaren Programmplatz (PR-NR) Kenndaten (Kanal-NR) eingebbar sind, die bei Anwählen des Programmplatzes (PR-NR) für Steuerzwecke ausgegeben werden, **gekennzeichnet durch** folgende Verfahrensschritte:
a) Bei Anwählen eines ersten Programmplatzes (PR-NR) wird durch zeitlich längeres Betätigen (1-4) sec. einer ersten Taste eine Zählschaltung zwecks Zeitmessung aktiviert und innerhalb der Betätigungszeit werden die dem Programmplatz (PR-NR) zugehörigen Daten (PR-NR und Kanal-NR) von einem Hauptspeicher (8) in einen ersten Hilfsspeicher (2) eingelesen,
b) bei anschließendem Auswählen des zweiten Programmplatzes (PR-NR) ebenfalls durch zeitlich längeres Betätigen (1-4 sec.) einer zweiten Taste innerhalb eines durch die Zählschaltung vorgegebenen Zeitfensters (5 sec.) werden die diesem Programmplatz (PR-NR) zugehörigen Daten (PR-NR und Kanal-NR.) von dem Hauptspeicher (8) in einen zweiten Hilfsspeicher (3), der auch Teil des ersten Hilfsspeichers (2) sein kann, eingelesen,
c) die Kenndaten des ersten Programmplatzes (Kanal-Nr.) werden dem zweiten Programmplatz (PR-NR) und die Kenndaten des zweiten Programmplatzes (Kanal-NR.) werden dem ersten Programmplatz (PR-NR) durch Datentausch zugeordnet und nach beendetem Tauschvorgang in dem Hauptspeicher (8) der Speichereinrichtung (1) bei Beibehaltung des einer Taste zugeordneten Programmplatzes neu gespeichert.

2. Verfahren nach Anspruch 1, **dadurch gekennzeichnet**, daß zwecks Kontrolle an einem Anzeigefeld (6) oder an einem Fernsehschirm Anzeigen über aufgerufene Programmplatz-Nummern (PR-NR) mit zugehörigen Kenndaten (Kanal-NR) nebst Sortierungsvorgang erfolgen.

3. Verfahren nach einem der Ansprüche 1 oder 2, **dadurch gekennzeichnet,** daß die Steuerung des Ablaufes durch einen Mikroprozessor (5) erfolgt.

4. Verfahren nach Anspruch 1, **dadurch gekennzeichnet**, daß der Datentausch in einem weiteren Hilfsspeicher erfolgt.

## Claims

1. Method for the sorting of program locations in an entertainment electronics device with which in a memory arrangement (1) reference data (channel-NR) can be input by way of programming for always one program location (PR-NR) addressable by one key from a keyboard (7), which for control purposes are output by addressing the program location (PR-NR), characterized by the following method steps:
a) Upon addressing of a first program location (PR-NR) by depressing a first key for a longer time (1 to 4 seconds) a counting circuit is activated for the purpose of timing and, within the operation time, data (PR-NR and channel-NR) allocated to the program location (PR-NR) are read into an auxiliary memory (2) from a main memory (8);
b) likewise, upon subsequent selection of the second program location (PR-NR) by depressing a second key for a longer time (1 to 4 seconds) within a time-window (5 seconds) pre-determined by the counting circuit the data (PR-NR and channel-NR) allocated to this program location (PR-NR) is read from the main memory (8) into a second auxiliary memory (3), which can also be part of the first auxiliary memory (2);
c) the reference data of the first program location (channel-NR) is allocated to the second program location (PR-NR) and the reference data of the second program location (channel-NR) is allocated to the first program location (PR-NR) by data exchange, and after the conclusion of the exchange process is again stored in the main memory (8) of the memory arrangement (1) while the program location allocated to a key is retained.

2. Method according to claim 1, characterized in that for the purpose of checking (supervision) addressed program location numbers (PR-NR) with corresponding reference data (channel-NR) and the sorting process are indicated by display on a display field (6) or on a television screen.

3. Method according to one of the claims 1 or 2, characterized in that the procedure is controlled by a microprocessor (5).

4. Method according to claim 1, characterised in that the data exchange occurs in a further auxiliary memory.

## Revendications

1. Procédé pour le tri d'emplacements de programme dans un appareil de l'électronique de loisirs dans lequel des données caractéristiques (n° de canal) peuvent être entrées dans un dispositif de mémoire (1) par programmation respectivement à un emplacement de programme (n° de programme) qui peut être sélectionné par une touche dans un clavier (7), ces données étant sorties à des fins de commande lors de la sélection de l'emplacement de programme (n° de programme), **caractérisé par**les étapes de procédé suivantes :
a) Lors de la sélection d'un premier emplacement de programme (n° de programme), en actionnant une première touche assez longtemps dans le temps (1 à 4 secondes), un circuit de comptage est activé pour comptage du temps et à l'intérieur du temps d'actionnement, les données (n° de programme et n° de canal) qui appartiennent à l'emplacement de programme (n° de programme) sont mises en mémoire d'une mémoire principale (8) dans une première mémoire auxiliaire (2),
b) lors de la sélection qui suit du second emplacement de programme, également en actionnant une seconde touche également pendant une durée assez longue dans le temps (1 à 4 secondes) à l'intérieur d'une fenêtre de temps (5 secondes) prédéfinie par le circuit de comptage, les données (n° de programme et n° de canal) qui appartiennent à cet emplacement de programme (n° de programme) sont mises en mémoire de la mémoire principale (8) dans une seconde mémoire auxiliaire (3) qui peut également être une partie de la première mémoire auxiliaire (2),
c) les données caractéristiques du premier emplacement de programme (n° de canal) sont affectées au second emplacement de programme (n° de programme) et les données caractéristiques du second emplacement de programme (n° de canal) sont affectées au premier emplacement de programme (n° de programme) par échange de données et, après que le processus d'échange soit terminé, mémorisées à nouveau dans la mémoire principale (8) du dispositif de mémoire (1) en conservant l'emplacement de mémoire affecté à une touche.

2. Procédé selon la revendication 1, **caractérisé en ce** que, pour contrôle, des affichages sur des numéros d'emplacements de programme appelés (n° de programme) avec les données caractéristiques correspondantes (n° de canal) se font, en plus de l'opération de tri, sur un champ d'affichage (6) ou sur un écran de télévision.

3. Procédé selon l'une des revendications 1 ou 2, **caractérisé en ce** que la commande du déroutement se fait par un microprocesseur (5).

4. Procédé selon la revendication 1, **caractérisé en ce** que l'échange de données se fait dans une autre mémoire auxiliaire.
